# EUROPÄISCHE PATENTSCHRIFT

(11) **EP 1 919 037 B1**
(45) Veröffentlichungstag und Bekanntmachung des Hinweises auf die Patenterteilung: **17.05.2017**
(21) Anmeldenummer: 07119458.3
(22) Anmeldetag: 29.10.2007
(51) Int. Cl.: H05K 5/00, H02K 5/22, H02K 11/33, H01R 13/504

(54) **Gehäuse und Verfahren zum Verbinden von Gehäuseteilen**
Casing and method for connecting casing parts
Boîtier et procédé de jonction des parties de boîtier

(30) Priorität: 06.11.2006 DE 102006052121
(43) Veröffentlichungstag der Anmeldung: 07.05.2008
(73) Patentinhaber: ROBERT BOSCH GMBH, 70442 Stuttgart (DE)
(72) Erfinder: Huber, Daniel, 72762, Reutlingen (DE); Silberbauer, Achim, 72762, Reutlingen (DE); Dillmann, Adolf, 72525, Muensingen (DE)

(56) Entgegenhaltungen:
- DE-A1- 1 591 445
- DE-A1- 3 238 850
- DE-A1- 4 201 401
- DE-C1- 19 820 603
- JP-A- 2004 120 860

## Beschreibung

### Stand der Technik

Die Erfindung geht aus von einem Gehäuse und einem Verfahren zum Verbinden von Gehäuseteilen nach der Gattung der unabhängigen Ansprüche.

Mit der DE 100 235 87 A1 ist ein Kupplungssteller einer Fahrzeugkupplung bekannt geworden, bei dem ein Gehäuse mit zwei Halbschalen eine Elektronikeinheit des Kupplungssteller-Motors umschließen. Die beiden Halbschalen werden mittels Schrauben miteinander verbunden, wobei ein Steckeranschluss mittels einer zusätzlichen Vorspanneinrichtung abgedichtet wird.

Für das Schließen eines solchen Gehäuses sind daher mehrere separate Verbindungsmittel notwendig, die in mehreren Montageschritten eingefügt werden müssen. Daher ist ein solches Verbindungsverfahren relativ aufwendig und teuer.

Aus der Offenlegungsschrift DE 3238850 A1 ist die Verbindung zweier Halbschalen mittels Zapfen und Hülsen bekannt. Die Zapfen und Hülsen sind derart ausgebildet, dass nach dem Fügen jeweils eine Rastverbindung ausgebildet ist. Hierzu weist der Zapfen im vorderen Bereich ein im Durchmesser zum Rest des Zapfen abstehendes Konusteil auf. Der Durchmesser des Konusteils ist größer als der Innendurchmesser einer Hülse.

Aus DE 4201401A1 ist eine Verbindung eines topfförmigen Gehäuseteils mit einem Bodenteil und einem Deckelteil bekannt. Das Deckelteil umfasst Hülsen und in die Hülsen formschlüssig eingefügte Kontaktstifte zum Ausbilden eines elektrischen Kontakts innerhalb des topfförmigen Gehäuseteils.

DE 19820603 C1 zeigt die Ausführung eines Schaltgehäuses für einen Akkupack. Dabei ist unter anderem ein Schaltrad vorgesehen, welches drehbar an einem Zapfen gehalten wird.

JP 2004120860A offenbart ein Verkabelungsgehäuse, welches beispielsweise in einer Wand installiert wird, um daraufhin eine Steckdose oder einen Schalter aufzusetzen. Es wird eine Lösung zur flexiblen Anpassung der Höhe des Verkabelungsgehäuse beschrieben. Demnach wird vorgeschlagen die Gehäusewandung aus mehreren Rahmenelementen aufzubauen, welche nach Bedarf in variabler Anzahl übereinander aufgestapelt werden können und somit flexibel auf eine benötigte Höhe des Verkabelungsgehäuses gebracht werden können. Für das Aufeinanderstapeln weisen die einzelnen Rahmen zum einen Dorne und zum anderen Vertiefungen auf. Beim Aufeinanderstapeln greifen dann Dorne jeweils eines Rahmens in Vertiefungen eines im Stapel vorhergehenden Rahmens ein.

### Offenbarung der Erfindung

### Vorteile der Erfindung

Das erfindungsgemäße Gehäuse und das Verfahren zum Verbinden von Gehäuseteilen mit den Merkmalen der unabhängigen Ansprüche haben demgegenüber den Vorteil, dass zum Verschließen des Gehäuses keine zusätzlichen, separaten Verbindungsmittel notwendig sind. Durch das Anformen der Zapfen an das eine Gehäuseteil und das Ausformen der Hülse am anderen Gehäuseteil können die beiden Gehäuseteile durch einfaches Zusammenpressen direkt miteinander verbunden werden, wobei eine unlösbare, dichte Bindung zwischen den Gehäuseteilen entsteht.

Durch die in den abhängigen Ansprüchen aufgeführten Maßnahmen sind vorteilhafte Weiterbildungen Verbesserungen der in den unabhängigen Ansprüchen angegebenen Merkmalen möglich. Zweckmäßigerweise weisen die Zapfen an ihren freien Enden Zentrierflächen auf, die die Zapfen exakt innerhalb eines korrespondierenden Zentrierbereichs der Hülsen positionieren. Dadurch wird der Monatagprozess sehr toleranzunempfindlich gestaltet.

Um eine definierte Einpresskraft zwischen den Zapfen und der Hülse zu erzielen, sind an dem Zapfen radiale Ausformungen angeformt, die sich zumindest über eine gewisse axiale Länge des Zapfens erstrecken. Diese radiale Fortsätze, die beispielsweise als axiale Stege ausgebildet sind, bilden eine Presspassung mit der Hülse des anderen Gehäuseteils.

Zur leichteren Einführung der Zapfen in die Hülse weist letztere insbesondere in ihrem oberen Teil radiale Aussparungen auf, sodass es beim Einführen der Zapfen in diesen Bereich noch nicht zu einer Presspassung zwischen dem Zapfen und der Hülse kommt. Dadurch kann der Kraftverlauf beim Einpressen der Zapfen in die Hülsen über den Einfügeweg entsprechend festgelegt werden.

Durch die entsprechende Abstimmung der radialen Fortsätze des Zapfens und der radialen Aussparung der Hülse kann beispielsweise die erforderliche Einpresskraft reduziert werden, und diese gegebenenfalls nur im letzten Teil des Einfügewegs zur Ausbildung eines sicheren Presssitzes gesteigert werden.

In einer alternativen Ausführung kann der Zapfen zusätzlich in der Hülse eingeklebt werden, um eine Lösung einer Verbindung zuverlässig zu verhindern.

Besonders vorteilhaft ist es, am Umfang der beiden Gehäuseteile eine umlaufende Dichtlippe auszubilden, die nach vollständigem Einführen der Zapfen in die Hülsen wasserdicht an einer entsprechenden Gegenfläche anliegt. Dadurch kann eine Steuerelektronik in einem Verfahrensschritt zuverlässig gegen Wasser und Schmutz abgedichtet werden.

In einer weiteren Ausgestaltung der Erfindung wird gleichzeitig mit dem Einfügen der Zapfen in die Hülse eine elektrische Verbindung des einen Gehäuseteils mit der in dem anderen Gehäuseteil angeordneten Elektronikeinheit hergestellt. Die elektrische Verbindung kann besonders günstig mittels einer Schneid- Klemm-Verbindung geschaffen werden, die zumindest teilweise an einem Stanzgitter angeformt ist.

Um zumindest Teile der Elektronikeinheit gegenüber einer Störstrahlung durch die Motorströme abzuschirmen, ist in der Trennebene zwischen den beiden Gehäuseteilen ein Abschirmblech angeordnet. Um eine zuverlässige Verbindung zwischen den beiden Gehäuseteilen herzustellen, weist das Abschirmblech Durchbrüche auf, in die die Zapfen eingreifen, um in die Hülsen eingefügt zu werden.

Bei einer ersten Ausführung des erfindungsgemäßen Verfahrens steigt die erforderliche Einfügekraft, mit dem der Zapfen in die Hülse eingepresst wird kontinuierlich über den Einfügeweg an, bis der Zapfen vollständig in die Hülse eingefügt ist. Dadurch kann über die Steigerung der Kraft im Endbereich des Fügeweges die Haltekraft der Verbindung beeinflusst werden. In einer weiteren Ausführung des erfindungsgemäßen Verfahrens durchläuft die Einfügekraft ein Maximum, das der Haltekraft der Verbindung entspricht. Danach kann der Zapfen mit geringerer Kraft weiter in die Hülse eingeschoben werden, um die beiden Gehäuseteile in eine gewünschte Position zueinander zu bringen.

Zur Vorzentrierung der beiden Gehäuseteile zueinander ist das freie Ende des Zapfens wird der obere Teil der Hülse derart ausgebildet, dass im ersten Teil des Einfügeweges während des Zentriervorgangs nur eine geringere Einfügekraft erforderlich ist, als am Ende des Einfügeweges.

Vorteilhaft kann gleichzeitig mit der Ausbildung der mechanischen Fügeverbindung ein oder mehrer elektrische Schneidklemmverbindungen ausgebildet werden. Durch die Messung des Fügekraftverlaufs kann dabei die korrekte Ausbildung der Schneidklemmverbindungen und eines mechanischen Press-Sitzes, bzw. einer Press-Passung überwacht werden kann, auch dann, wenn die Schneidklemmverbindungen nicht sichtbar sind. Durch die Einstellung einer maximal zulässigen Fügekraft kann der Fügeprozess definiert beendet werden, sodass immer eine zuverlässige Verbindung durch den gleichen Kraftschluss gewährleistet ist.

### Kurze Beschreibung der Zeichnungen

Ausführungsbeispiele der Erfindungen sind in den Zeichnungen dargestellt und in der nachfolgenden Beschreibung näher erläutert. Es zeigen
- Figur 1: ein Schnitt durch ein erfindungsgemäßes Gehäuse, und
- Figur 2: einen Querschnitt durch ein Zapfen gemäß Figur 1
- Figur 3: eine Explosionsdarstellung der zu verbindenden Bauteile, und
- Figur 4: einen Kraftverlauf für den Fügevorgang gemäß Figur 3

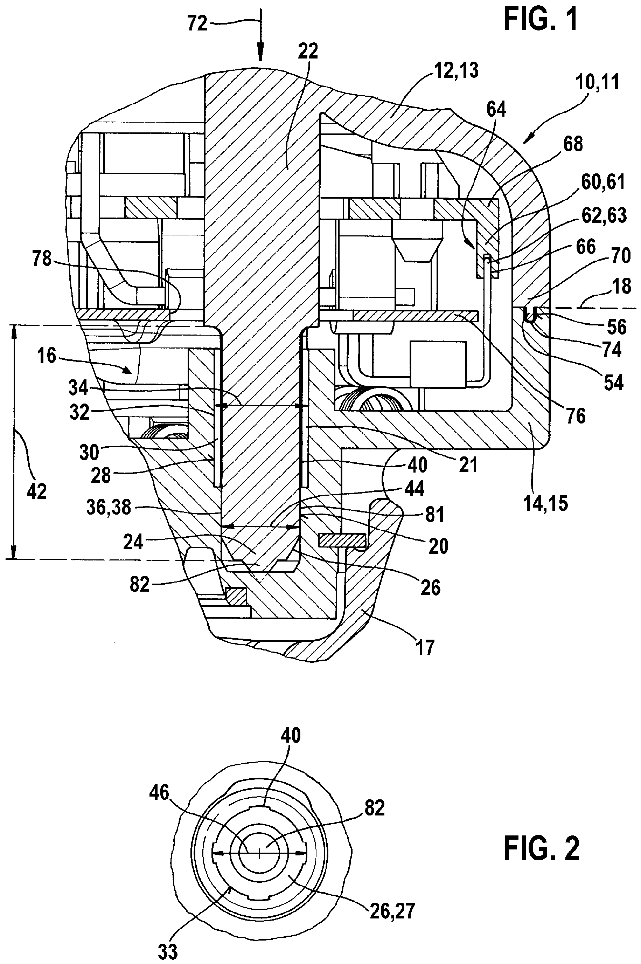

In Figur 1 ist ein Gehäuse 10 dargestellt, dass ein erstes Gehäuseteil 12 und ein zweites Gehäuseteil 14 aufweist. Das erste Gehäuseteil 12 ist beispielsweise als untere Halbschale ausgebildet, in der eine Elektronikeinheit 16 angeordnet ist. Zum Verschließen des ersten Gehäuseteils 12 ist das zweite Gehäuseteil 14 als Deckel ausgebildet, sodass die beiden Gehäuseteile 12 und 14 an einer Trennebene 18 aneinander anliegen. Am ersten Gehäuseteil 12, das beispielsweise aus Kunststoff ausgebildet ist, ist eine Hülse 20 ausgebildet, in die zum Schließen des Gehäuses 10 ein Zapfen 22 eingreift, der am zweiten Gehäuseteil 14 angeformt ist. Der Zapfen 22 ist im Ausführungsbeispiel einstückig mit dem ersten Gehäuseteil 12 ausgebildet, vorzugsweise als Kunststoff- Spritzgussteil. Der Zapfen 22 weist an einem freien Ende 24 chronisch zugespitzte Flächen 26 auf, mit den der Zapfen 22 in einen Zentrierbereich 28 der Hülse 22 zuerst eingreift. Der Zentrierbereich 28 erstreckt sich über einen oberen Teil 30 der Hülse 22 und weist hier radiale Aussparungen 30 auf, damit der Zapfen beim Einfügen noch nicht eingepresst wird, sondern beim Einführen in den Zentrierbereich 28 lediglich das zweite Gehäuseteil 14 exakt zum ersten Gehäuseteil 12 positioniert, bzw. zentriert wird. Der Zentrierbereich 28 weist beispielsweise über den gesamten Umfang 32 ein größeren Durchmesser 34 auf als ein entsprechender Pressbereich36 im unteren Teil 38 der Hülse 20. Alternativ können sich die Aussparungen 30 jedoch auch nur teilweise über den Umfang 32 erstrecken. Am Zapfen 22 sind radiale Fortsätze 40 ausgebildet, die sich im Ausführungsbeispiel näherungsweise über die gesamte axiale Länge 42 des Zapfens 22 erstrecken. Im Pressbereich 36 ist der Durchmesser 44 geringer, als der Durchmesser 46 der radialen Fortsätze 40 des Zapfens 22. Daher wird der Zapfen 22 im Pressbereich 36 festgeklemmt, wodurch das zweite Gehäuseteil 14 exakt positioniert gegenüber dem ersten Gehäuseteil 12 fixiert ist. Während dem Einfügen des Zapfens 22 über den gesamten Einfügeweg 50 wird das zweite Gehäuseteil 14 mit relativ geringer Kraft 52 in den Zentrierbereich 28 eingefügt, wodurch eine umlaufende Dichtlippe 54 gegenüber einer umlaufenden Nut 56 positioniert wird. Gleichzeitig werden korrespondierende Elemente 60, 62 einer Schneid-Klemm-Verbindung 64 derart gegeneinander positioniert, dass mit dem Einfügen des Zapfens 22 in den Pressbereich 36 gleichzeitig die Schneid-Klemm-Elemente 60, 62 ineinander gefügt werden, um einen elektrischen Kontakt 66 zu erzeugen. Im Ausführungsbeispiel ist das Schneid-Klemm-Element 60 als Klemme 61 ausgebildet, in die als zweites Schneid-Klemm-Element 62 ein Pin 63 eingefügt wird. Die Klemme 61 ist beispielsweise an ein Stanzgitter 68 angeformt, das im ersten Gehäuseteil 12 angeordnet ist und vorzugsweise einen elektrischen Steckkontakt des Gehäuses 10 zu einer externen Stromversorgung bildet. Die Schneid-Klemm-Verbindung 64 stellt hier die elektrische Verbindung zwischen der Elektronikeinheit 16 und dem Stanzgitter 68 her, wobei die Schneid-Klemm-Elemente 60, 62 alternativ auch ausgetauscht in den beiden Gehäuseteilen 12 und 14 angeordnet sein können.

Des Weiteren ist in der Trennebene 18 zwischen den beiden Gehäuseteilen 12 und 14 Klebemittel angeordnet, so dass beim vollständigen Einführen des Zapfens 22 in die Hülse nicht nur ein elektrischer Kontakt 66 hergestellt wird, sondern auch die beiden Gehäuseteile 12 und 14 derart im Bereich ihres Umfangs 70 derart in Fügerichtung 72 aneinander gepresst werden, dass die beiden Gehäuseteile 12 und 14 miteinander verklebt werden. Vorzugsweise ist das Klebemittel 74 zwischen der Dichtlippe 54 und der Nut 56 angeordnet. Das Gehäuse 10 wird nach dem vollständigen Einfügen des Zapfens 22 in den Pressbereich 36 derart erwärmt, dass das Klebemittel 74 aushärtet, beispielsweise bei 100 bis 130°C. Dabei bildet der Zapfen 22 einen festen Presssitz in der Hülse 20, so dass das obere Gehäuseteil 12 während der Erwärmung nicht aufgeschwemmt wird. Zur Abschirmung der Elektronikeinheit 16 ist zwischen den beiden Gehäuseteilen 12 und 14 ein Abschirmblech 76 angeordnet. Das Abschirmblech 76 weist Durchbrüche 78 auf, durch die die Zapfen 22 hindurch ragen, um in die Hülse 20 eingeführt zu werden. Das gesamte Gehäuse 10 ist beispielsweise axial auf einem Elektromotor 80 angeordnet, der durch die Elektronikeinheit 16 angesteuert wird. Das Gehäuse 10, das beispielsweise als Elektronikgehäuse 11 eines Steuergeräts ausgebildet ist, kann dabei auch mehr als zwei Gehäuseteile 12, 14, aufweisen, wobei beispielsweise ein Gehäuseteil 14 als Gehäuserahmen 15 ausgebildet ist, der von zwei Gehäuseschalen 13, 17 umschlossen wird.

In Figur 2 ist eine Draufsicht von unten auf den Zapfen 22 dargestellt, der erst bis in den Zentrierbereich 28 der Hülse 20 eingeführt ist. Der Zapfen 22 weist beispielsweise vier radiale Fortsätze 40 auf, die jeweils gegenüberliegend angeordnet sind. Die radialen Fortsätze 40 erstrecken sich über die gesamte axiale Ausdehnung 42 des Zapfens 22, wie in Figur 1 ersichtlich ist. Am freien Ende 24 weist der Zapfen 22 eine kegelförmige Spitze 82 auf, am Umfang 33 des Zapfens 22 ist die konische Fläche 26 angeformt, die hier als Kegelstumpf 27 ausgebildet ist. Ist der Zapfen 22 erst ein Teil des Einfügeweges 50 bis in den Zentrierbereich 28 eingefügt, ist zwischen den Zapfen 22 und der Hülse 20 noch Spiel 21 vorhanden. Erst beim Einführen in den Pressbereich 36 im letzten Teil des Einfügewegs 50 bildet der Zapfen 22 eine feste Pressung, die die beiden Gehäuseteile 12 und 14 zuverlässig bezüglich der Einfügerichtung 72 zueinander verbindet.

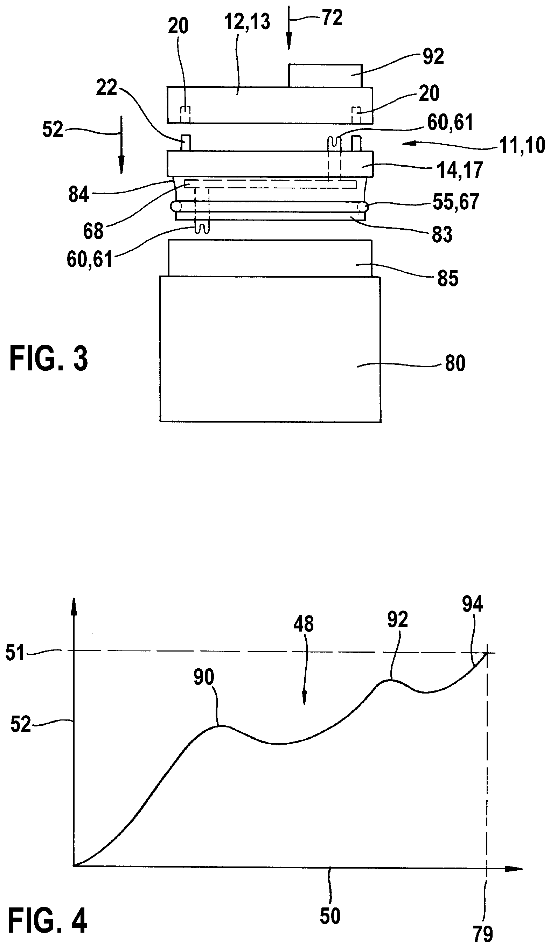

In Figur 3 sind schematisch nochmals verschiedene Bauteile 12, 14, 10, 80 eines Lenkhilfeantriebs dargestellt, die mittels einer Schneidklemmverbindung 64 und einer mechanischen Fügeverbindung miteinander verbunden werden können. Beispielsweise werden einerseits die Gehäuseschalen 12 und 14 mittels den Schneid-Klemm-Elementen 60, 62 miteinander verbunden, und andererseits das zusammengefügte Gehäuse 10, das als Elektronikgehäuse 11 ausgebildet ist, mit dem Elektromotor 80. Dabei ist das Stanzgitter 68 innerhalb der Gehäuseteils 14 derart angeordnet, dass sich die Scheid-Klemm-Elemente 60, 61 vom Stanzgitter 68 nach oben zur ersten Gehäuseschale 12 und nach unten zum Elektromotor 80 hin erstrecken und in entsprechende zweite Schneid-Klemm-Elemente 62, 63 dieser Bauteile greifen. Mit der mechanische Verbindung der einzelnen Bauteile wird gleichzeitig eine Schneidklemmverbindung 64 geschaffen, die innerhalb des abgeschlossenen Gehäuses 10 nicht mehr sichtbar ist. Zwischen dem Elektronikgehäuse 11 und dem Elektromotor 80 ist eine Dichtung 55 angeordnet, die beim Zusammenfügen zusammengepresst wird, was einen Anstieg der Fügekraft 52 zur Folge hat. Ist die Dichtung 55 vollständig verformt, nimmt die Fügekraft 52 über den weiteren Fügeweg 50 wieder ab. Am Ende79 des Fügewegs 50 wird eine Presspassung 81 ausgebildet, die zwischen den umlaufenden Wänden 83, 85 der Bauteile 10 und 80 und/oder zwischen einem Zapfen 22 und einer korrespondierenden Hülse 20 angeordnet sein kann. Dabei kann die umlaufende wand 83 des Gehäuses 10, die in die äußere umlaufende Wand 85 des Elektromotors 80 eingefügt wird ebenfalls als ein Zapfen 20, 83 verstanden werden, der in eine entsprechende Hülse 22, 85 eingefügt wird, bis am Ende 79 des Fügewegs 50 jeweils eine Presspassung 81 ausgebildet wird. Hierzu ist an der umlaufenden Wand 83 eine Verdickung 84 angeformt, die beim vollständigen Einfügen einen Press-Sitz bewirkt. Die Schneidklemmverbindungen 64 eignen sich besonders für die Zuführung eines Motorstroms über einen Anschluss-Stecker 92, bei denen beispielsweise Ströme von 50 bis 150 Ampere fließen können.

In Fig. 4 ist ein Kraftverlauf 48 der Fügekraft 52 gegenüber dem Fügeweg 50 beim Verbinden der Bauteile 12 und 14, bzw. 10 und 80 gemäß Fig. 3 dargestellt. Das erste lokale Maximum 90 des Kraftverlaufs 48 entspricht dem Verformen der Dichtung 55, die beispielsweise als O-Ring 67 ausgebildet ist, der zwischen den beiden Bauteilen 80 und 10 eingeklemmt wird. Nach der Verformung der Dichtung 55 nimmt die Einfügekraft 52 wieder ab, bis es zu einem erneuten Kraftanstieg mit einem weiteren Kraftmaximum 92 kommt, das durch das Ineinanderfügen der beiden Schneid-Klemm-Elemente 60, 62 erzeugt wird. Je nach konkreter Ausgestaltung der Schneid-Klemm-Elemente 60, 62 nimmt die Einfügekraft 52 aufgrund der Gleitreibung zwischen den beiden Schneid-Klemm-Elementen 60, 62 wieder ab, bis es zu einem erneute Kraftanstieg 94 am Ende 79 des Einfügewegs 50 kommt, der durch die Ausbildung einer Presspassung 81 zwischen den beiden Bauteilen 80, 10 (Verdickung 84) oder des Zapfens 22 in der Hülse im Pressbereich 36 verursacht wird. Wird beim Zusammenfügen der beiden Bauteile 12 und 14, bzw. 10 und 80 ein solcher Kraftverlauf 48 gemessen, kann anhand der Messkurve kontrolliert werden, ob die Schneid-Klemm-Verbindung 64 und die Presspassung 81 zwischen den einzelnen Bauteilen 12, 14 und 10, 80 ordnungsgemäß zustande gekommen ist. Bei einer vom Sollverlauf abweichenden Messkurve, kann hingegen auf eine fehlerhafte Verbindung, beispielsweise durch Abknicken eines Schneid-Klemm-Elements 60, 62 oder einer Beschädigung der Bauteile 12, 14, 80 bzw. der Dichtung 55 geschlossen werden. Außerdem kann beim Fügeprozess eine maximale Fügekraft 52 vorgegeben werden, bei der der Fügevorgang automatisch beendet wird, nachdem am Ende 79 des Fügeweges 50 die Presspassung 81 ausgebildet wurde. Dadurch ist gewährleistet, dass die mechanische Verbindung zwischen den Bauteilen 12, 14 und 10, 80 immer durch einen gleichmäßig ausgebildeten Press-Sitz 81 gegeben ist.

Es sei angemerkt, dass hinsichtlich der in den Figuren gezeigten Ausführungsbeispiele vielfältige Kombinationsmöglichkeiten der einzelnen Merkmale untereinander möglich sind. So können beispielsweise die radialen Aussparungen 30 und die radialen Fortsätze 40 einerseits der erforderlichen Zentriergenauigkeit und andererseits den erforderlichen Haltekräften in Einfügerichtung 72 angepasst werden. Ebenso kann zur Abdichtung der beiden Gehäuseteile 12 und 14 deren Dichtung 54, 55 variiert werden, wobei vorzugsweise das Gehäuse 10 wasserdicht abgeschlossen sein soll. Die Ausgestaltung der Elektronikeinheit 16 und der elektrischen Kontakte 66 innerhalb des Gehäuses 10 können ebenfalls entsprechend der Verwendung des Gehäuses 10 verändert werden. Bevorzugt wird das Gehäuse 10 als Steuergerät für einen Lenkhilfeantrieb ausgebildet, der bei Betätigung des Lenkrads eines Kraftfahrzeugs das Einstellen eines Lenkwinkels der Räder motorisch unterstützt.

## Patentansprüche

1. Gehäuse (10) für eine Elektronikeinheit mit einem ersten Gehäuseteil (12) und einem zweiten Gehäuseteil (14), wobei am ersten Gehäuseteil (12) Zapfen (22) angeordnet sind, die in Hülsen (20) eingreifen, die am zweiten Gehäuseteil (14) ausgeformt sind, wobei zum Verschließen des Gehäuses (1) das erste Gehäuseteil (12) oder das zweite Gehäuseteil (14) als Deckel ausgebildet ist, **dadurch gekennzeichnet, dass** die Hülse (20) in ihrem oberen Teil einen Zentrierbereich (28) aufweist, in welchen der Zapfen (22) beim Fügen in die Hülse (20) zuerst greift, wobei im Zentrierbereich (28) zwischen dem Zapfen (18) und der Hülse (20) Spiel vorhanden ist, und dass die Hülse (20) in ihrem unteren Teil einen Pressbereich (36) aufweist, wobei im Pressbereich (36) der Zapfen nur mit Teilen seines Umfangs (32) und/oder nur mit einem Teil seiner axialen Ausdehnung (42) kraftschlüssig an der Hülse (20) anliegt, wodurch eine Presspassung zwischen der Hülse (20) und dem Zapfen (22) ausgebildet ist.

2. Gehäuse (10) nach Anspruch 1, **dadurch gekennzeichnet, dass** der Zapfen (22) am freien Ende (24) einen Konus (26) aufweist, der den Zapfen (22) in dem Zentrierbereich (28) der Hülse (20) zentriert.

3. Gehäuse (10) nach einem der Ansprüche 1 oder 2, **dadurch gekennzeichnet, dass** der Zapfen (22) radiale Fortsätze (40) aufweist, die nach dem Einfügen des Zapfen (22) in die Hülse (20) in dieser eingepresst sind.

4. Gehäuse (10) nach einem der vorhergehenden Ansprüche, **dadurch gekennzeichnet, dass** die Hülse (20) radiale Aussparungen (30) aufweist, die sich insbesondere nur über einen oberen Teil der axialen Länge der Hülse (20) erstrecken.

5. Gehäuse (10) nach einem der vorhergehenden Ansprüche, **dadurch gekennzeichnet, dass** die beiden Gehäuseteile (12, 14) eine unlösbare Verbindung mit einer umlaufenden wasserdichten Dichtlippe (54) bilden, und insbesondere eine Steuerelektronik (16) umschließen.

6. Gehäuse (10) nach einem der vorhergehenden Ansprüche, **dadurch gekennzeichnet, dass** die Dichtlippe (54) in eine umlaufende Nut (56) eingreift, in der insbesondere Klebemittel (74) angeordnet ist.

7. Gehäuse (10) nach einem der vorhergehenden Ansprüche, **dadurch gekennzeichnet, dass** mit dem Einfügen des Zapfens (22) in die Hülse (20) zugleich eine elektrische Schneid-Klemmverbindung (64) ausgebildet wird, die insbesondere einen elektrischen Kontakt (66) zwischen der Elektronikeinheit (16) und einem Stanzgitter (68) bildet.

8. Gehäuse (10) nach einem der vorhergehenden Ansprüche, **dadurch gekennzeichnet, dass** zwischen den beiden Gehäuseteilen (12, 14) ein Abschirmblech (76) angeordnet ist, das Durchbrüche (78) aufweist, durch die die Zapfen (22) durchgreifen.

9. Verfahren zum Verbinden zweier Gehäuseteile (12, 14) eines Elektronikeinheitsgehäuses, wobei am ersten Gehäuseteil (12) Zapfen (22) angeordnet sind, die mittels einer Einfügekraft (52) entlang eines Einfügeweges (50) in Hülsen (20) eingefügt werden, die am zweiten Gehäuseteil (14) ausgeformt sind, wobei zum Verschließen des Elektronikeinheitsgehäuses das erste Gehäuseteil (12) oder das zweite Gehäuseteil (14) als Deckel vorgesehen wird, **dadurch gekennzeichnet, dass** der Zapfen (22) im ersten Teil des Einfügeweges (50) in einem Zentrierbereich (28) der Hülse vorzentriert wird, wobei im Zentrierbereich (28) zwischen dem Zapfen (18) und der Hülse (20) Spiel vorhanden ist, und im zweiten Teil des Einfügeweges (50) - insbesondere an dessen Ende (79) - mit einer Innenwand der Hülse (20) verpresst wird, um eine Presspassung zwischen der Hülse (20) und dem Zapfen (22) auszubilden, wodurch die beiden Gehäuseteile (12, 14) unverrückbar zueinander positioniert werden.

10. Verfahren nach Anspruch 9, **dadurch gekennzeichnet, dass** während des Zusammenfügens der Zapfen (22) in die Hülsen (20) eine am Umfang vom ersten und zweiten Gehäuseteil (12,14) umlaufende Dichtung (54, 55) zwischen diesen eingeklemmt wird und/oder eine elektrische Verbindung des einen Gehäuseteils mit einer in dem anderen Gehäuseteil angeordneten Elektronikeinheit hergestellt wird, wobei die elektrische Vebrindung insbesondere durch koresspondierende Schneid-Klemm-Elemente hergestellt wird, und dass während des Zusammenfügens ein Kraftverlauf (48) der Fügekraft (52) gemessen wird, um eine fehlerhafte Ausbildung der mechansichen und/oder elektrischen Verbindung zu erkennen, und insbesondere der gemessene Kraftverlauf (48) der Fügekraft (52) mit einer Sollwertkurve des Kraftverlaufs verglichen wird.

11. Verfahren nach Anspruch 10, **dadurch gekennzeichnet, dass** der gemessene Kraftverlauf (48) auf das Vorliegen mindestens eines oder mehrere lokale Maxima (90, 92, 94) kontrolliert wird, wobei ein Maximum (90, 92, 92) dem Verformen der Dichtung oder einem Ineinanderfügen der Schneid-Klemm-Elemente oder der Ausbildung der Presspassung zwischen den Zapfen und den Hülsen entspricht, und wobei bei Vorliegen des einen oder der mehreren lokalen Maxima auf eine ordnungsgemäße Ausbildung einer Schneidklemmverbindung (64) und/oder einer mechanischen Fügeverbindung bzw. einen Press-Sitz (81) geschlossen wird.

12. Verfahren nach einem der vorhergehenden Ansprüche, **dadurch gekennzeichnet, dass** beim Zusammenfügen der Bauteile eine maximal erlaubte Fügekraft (52) vorgegeben wird, die als Abschaltkriterium für den Fügeweg (50) verwendet wird.

## Claims

1. Housing (10) for an electronics unit, comprising a first housing part (12) and a second housing part (14), wherein pins (22) are arranged on the first housing part (12) and engage in sleeves (20) which are formed on the second housing part (14), wherein the first housing part (12) or the second housing part (14) is in the form of a cover in order to close the housing (1), **characterized in that** the sleeve (20) has, in its upper part, a centring region (28) in which the pin (22) first extends into the sleeve (20) during joining, wherein there is play between the pin (18) and the sleeve (20) in the centring region (28), and **in that** the sleeve (20) has a press region (36) in its lower part, wherein, in the press region (36), the pin bears against the sleeve (20) in a force-fitting manner only by way of parts of its circumference (32) and/or only by way of one part of its axial extent (42), as a result of which a press-fit is formed between the sleeve (20) and the pin (22).

2. Housing (10) according to Claim 1, **characterized in that** the pin (22) has, at its free end (24), a cone (26) which centres the pin (22) in the centring region (28) of the sleeve (20).

3. Housing (10) according to either of Claims 1 and 2, **characterized in that** the pin (22) has radial projections (40) which, after the pin (22) is inserted into the sleeve (20), are pressed into the said sleeve.

4. Housing (10) according to one of the preceding claims, **characterized in that** the sleeve (20) has radial cutouts (30) which extend, in particular, only over an upper part of the axial length of the sleeve (20).

5. Housing (10) according to one of the preceding claims, **characterized in that** the two housing parts (12, 14) form a permanent connection with a peripheral water-tight sealing lip (54), and in particular surround a control electronics system (16).

6. Housing (10) according to one of the preceding claims, **characterized in that** the sealing lip (54) engages into a peripheral groove (56) in which, in particular, adhesive (74) is arranged.

7. Housing (10) according to one of the preceding claims, **characterized in that**, when the pin (22) is inserted into the sleeve (20), an electrical insulation-displacement connection (64) is formed at the same time, the said electrical insulation-displacement connection forming, in particular, an electrical contact (66) between the electronics unit (16) and a stamped grid (68).

8. Housing (10) according to one of the preceding claims, **characterized in that** a shielding plate (76) is arranged between the two housing parts (12, 14), the said shielding plate having apertures (78) through which the pins (22) pass.

9. Method for connecting two housing parts (12, 14) of an electronics unit housing, wherein pins (22) are arranged on the first housing part (12), the said pins being inserted into sleeves (20), which are formed on the second housing part (14), by means of an insertion force (52) along an insertion distance (50), wherein the first housing part (12) or the second housing part (14) is provided as a cover in order to close the electronics unit housing, **characterized in that** the pin (22) is preliminarily centred in a centring region (28) of the sleeve in the first part of the insertion distance (50), wherein there is play between the pin (18) and the sleeve (20) in the centring region (28), and the pin is pressed with an inner wall of the sleeve (20) in the second part of the insertion distance (50) - in particular at its end (79) - in order to form a press-fit between the sleeve (20) and the pin (22), as a result of which the two housing parts (12, 14) are positioned in relation to one another such that they cannot be moved.

10. Method according to Claim 9, **characterized in that**, during the joining of the pin (22) into the sleeves (20), a seal (54, 55) which runs around the circumference of the first and second housing part (12, 14) is clamped between the said housing parts and/or an electrical connection of one housing part to a electronics unit which is arranged in the other housing part is established, wherein the electrical connection is established, in particular, by corresponding insulation-displacement elements, and **in that**, during the joining operation, a force profile (48) of the joining force (52) is measured in order to identify faulty formation of the mechanical and/or electrical connection, and in particular the measured force profile (48) of the joining force (52) is compared with a setpoint value curve of the force profile.

11. Method according to Claim 10, **characterized in that** the measured force profile (48) is monitored for the presence of at least one or more local maxima (90, 92, 94), wherein a maximum (90, 92, 92) corresponds to the deformation of the seal or to insertion of the insulation displacement elements or the formation of a press-fit between the pin and the sleeves, and wherein, when there is/are one or more local maxima, it is concluded that an insulation-displacement connection (64) and/or a mechanical joining connection or a press-fit (81) is correctly formed.

12. Method according to one of the preceding claims, **characterized in that**, when the components are joined, a maximum permissible joining force (52) is specified, this being used as a shut-down criterion for the joining distance (50).

## Revendications

1. Boîtier (10) destiné à une unité électronique comportant une première partie de boîtier (12) et une deuxième partie de boîtier (14), dans lequel il est prévu sur la première partie de boîtier (12) des broches (22) s'engageant dans des manchons (20) qui sont formés sur la deuxième partie de boîtier (14), dans lequel la première partie de boîtier (12) ou la deuxième partie de boîtier (14) est réalisée sous la forme d'un capot permettant de refermer le boîtier (1), **caractérisé en ce que** le manchon (20) présente dans sa partie supérieure une zone de centrage (28) dans laquelle s'engage en premier lieu la broche (22) lors de l'assemblage dans le manchon (20), dans lequel un jeu est présent dans la zone de centrage (28) entre la broche (18) et le manchon (20) et **en ce que** le manchon (20) présente dans sa partie inférieure une zone de pression (36), dans lequel la broche n'est en contact par complémentarité de force avec le manchon (20) dans la zone de pression (36) que par l'intermédiaire de parties de sa circonférence (32) et/ou que par l'intermédiaire d'une partie de son extension axiale (42), d'où il résulte qu'une adaptation par pression est établie entre le manchon (20) et la broche (22).

2. Boîtier (10) selon la revendication 1, **caractérisé en ce que** la broche (22) présente à l'extrémité libre (24) un cône (26) qui centre la broche (22) dans la zone de centrage (28) du manchon (20).

3. Boîtier (10) selon l'une quelconque des revendications 1 ou 2, **caractérisé en ce que** la broche (22) présente des protubérances radiales (40) qui sont insérées dans celle-ci après l'introduction de la broche (22) dans le manchon (20).

4. Boîtier (10) selon l'une quelconque des revendications 1 ou 2, **caractérisé en ce que** le manchon (20) comporte des évidements (30) qui ne s'étendent notamment que sur une partie supérieure de la longueur axiale du manchon (20).

5. Boîtier (10) selon l'une quelconque des revendications précédentes, **caractérisé en ce que** les deux parties de boîtier (12, 14) forment une liaison inamovible avec une lèvre d'étanchéité (54) circonférentielle étanche à l'eau et **en ce qu'**elles enveloppent notamment une électronique de commande (16).

6. Boîtier (10) selon l'une quelconque des revendications précédentes, **caractérisé en ce que** la lèvre d'étanchéité (54) s'engage dans une rainure circonférentielle (56) dans laquelle est notamment disposé un adhésif (74).

7. Boîtier (10) selon l'une quelconque des revendications précédentes, **caractérisé en ce qu'**il se forme une liaison par encliquetage-serrage (64) électrique en même temps que l'insertion de la broche (22) dans le manchon (20), qui forme notamment un contact électrique (66) entre l'unité électronique (16) et une grille estampée (68).

8. Boîtier (10) selon l'une quelconque des revendications précédentes, **caractérisé en ce qu'**il est prévu entre les deux parties de boîtier (12, 14) une tôle de blindage (76) qui présente des traversées (78) à travers lesquelles s'engagent les broches (22).

9. Procédé de liaison de deux parties de boîtier (12, 14) d'un boîtier d'unité électronique, dans lequel il est prévu sur la première partie de boîtier (12) des broches (22) qui sont insérées au moyen d'une force d'insertion (52) le long d'un trajet d'insertion (50) dans des manchons (20) qui sont formés sur la deuxième partie de boîtier (14), dans lequel la première partie de boîtier (12) ou la deuxième partie de boîtier (14) est prévue en tant que capot permettant de refermer le boîtier d'unité électronique, **caractérisé en ce que** la broche (22) est préalablement centrée dans la première partie du trajet d'insertion (50), dans une zone de centrage (28) du manchon, dans lequel un jeu est présent dans la zone de centrage (28) entre la broche (18) et le manchon (20) et **en ce que**, dans la deuxième partie du trajet d'insertion (50) - notamment à son extrémité (79) - elle est comprimée sur une paroi interne du manchon (20) afin de former une adaptation par compression entre le manchon (20) et la broche (22), d'où il résulte que les deux parties de boîtier (12, 14) sont positionnées de manière non déplaçable l'une par rapport à l'autre.

10. Procédé selon la revendication 9, **caractérisé en ce que**, pendant l'assemblage des broches (22) dans les manchons (20), un élément d'étanchéité (54, 55) circonférentiel prévu sur la circonférence des première et deuxième parties de boîtier (12, 14) est bloqué entre celles-ci et/ou une liaison électrique de l'une des parties de boîtier est établie avec une unité électronique disposée dans l'autre partie de boîtier, dans lequel la liaison électrique est notamment établie par l'intermédiaire d'éléments d'encliquetage-serrage correspondants, et **en ce que**, pendant l'assemblage, une variation de force (48) de la force d'assemblage (52) est mesurée afin d'identifier une réalisation défaillante de la liaison mécanique et/ou électrique, la variation de force (48) mesurée de la force d'assemblage (52) étant notamment comparée à une courbe nominale de la variation de force.

11. Procédé selon la revendication 10, **caractérisé en ce que** la variation de force (48) mesurée est contrôlée en ce qui concerne la présence d'au moins un ou plusieurs maxima locaux (90, 92, 94), dans lequel un maximum (90, 92, 92) correspond à la formation de l'élément d'étanchéité ou à l'emboîtement l'un dans l'autre d'éléments d'encliquetage-serrage ou à la formation de l'adaptation par compression entre les broches et les manchons, et dans lequel, dans le cas de la présence d'un ou plusieurs maxima locaux, il en est conclu qu'il s'est formé une liaison par encliquetage-serrage (64) et/ou une liaison d'assemblage mécanique ou un ajustement serré (81).

12. Procédé selon l'une quelconque des revendications précédentes, **caractérisé en ce que**, lors de l'assemblage des composants, une force d'assemblage (52) admissible maximale, qui est utilisée en tant que critère de désactivation pour le trajet d'insertion (50), est déterminée à l'avance.
